# EUROPEAN PATENT APPLICATION

(11) **EP 1 693 887 A1**
(43) Date of publication of application: **23.08.2006**
(21) Application number: 04793107.6
(22) Date of filing: 28.10.2004
(51) Int. Cl.: H01L 21/306, H01L 21/308

(54) **PROCESSING METHOD OF SILICON WAFER**

(30) Priority: 10.12.2003 JP 2003411287
(71) Applicant: SUMCO Corporation, Minato-ku Tokyo (JP)
(72) Inventor: KOYATA, Sakae,SUMITOMO MITSUBISHI SILICON CO, Tokyo 1058634 (JP); TAKAISHI, Kazushige,SUMITOMO MITSUBISHI SILICON CO, Tokyo 1058634 (JP)
(74) Representative: Bublak, Wolfgang
(86) International application number: PCT/JP2004/015999
(87) International publication number: WO 2005/057645

(57) **Abstract**

The processing method of a silicon wafer of the present invention includes an etching process (13) in which acid etching solution and alkali etching solution are stored in plural etching tanks, respectively and a wafer having degraded superficial layers gone through a cleaning process (12) subsequent to a lapping process (11) is immersed into the acid etching solution and the alkali etching solution in order, a front surface mirror-polishing process (18) to mirror-polish one surface of the etched wafer, and a cleaning process (19) to clean the front surface mirror-polished wafer, wherein the etching process is performed by the alkali etching after the acid etching, and wherein the acid etching solution contains phosphoric acid equal to or more than 30 percent by weight in the acid aqueous water solution 100 percent by weight mainly composed of hydrofluoric acid and nitric acid. The processing method of the present invention maintains the flatness after lapping, and at the same time, can reduce the surface roughness. Further, in the wafer in which the front surface is mirror-polished, a good flatness is obtained, and moreover, the rear surface roughness becomes small.

## Description

### Technical Field

The present invention relates to improvement of a method to etching-remove degraded superficial layers of the wafer generated in the manufacturing process of a silicon wafer. More in particular, it aims at providing a processing method of a silicon wafer in which both surfaces of the wafer have highly accurate flatness, and moreover, which are identifiable by visually observing the front and rear surfaces of the wafer.

### Background Art

In general, the manufacturing process of a semiconductor wafer is constituted by process flow in which a wafer obtained by slicing out from a pulled out silicon single crystal ingot is chamfered, mechanically polished (lapped), etched, mirror-polished (polished) , and cleaned so as to be produced as a wafer having a highly accurate flatness. These processes are partially replaced according to the purpose, repeated several times or added and substituted with other processes such as heat treatment, grinding, and the like, and various processes are performed.
The silicon wafer gone through machining process such as block cutting off, outer diameter grinding, slicing, lapping and the like has damaged layers, that is, degraded superficial layers in the surface. The degraded superficial layers induce a crystal defect such as a slip dislocation and the like in a device manufacturing process, and reduce mechanical strength of the wafer, and exert adverse effect on electrical characteristics, and therefore, must be completely removed.

To remove these degraded superficial layers, an etching processing is performed. The etching processing includes an acid etching using an acid etching solution such as mixed acid and the like, and an alkali etching using an alkali etching solution such as NaOH and the like.
However, when the acid etching is performed, the flatness obtained by lapping is harmed, and a warp in mm order and unevenness called as peel are generated in the etching surface. Further, there has been a problem in that when the alkali etching is performed, a pit (hereinafter referred to as a facet) having a local depth of several µm and a size of approx several tens of µm is generated.

As the method of solving the above described problem, there is proposed a processing method of the wafer and the wafer processed by this method in which the etching process is performed after the alkali etching, and at this time, an etching removal depth of the alkali etching is made larger than the etching removal depth of the acid etching (for example, see Patent Document 1).
By the method shown in the Patent Document 1, it is possible to remove degraded superficial layers while the flatness after the lapping is maintained, improve the surface roughness and in particular, prepare the wafer having a local facet much shallower and a smooth uneven shape and having an etching surface hard to develop contamination such as particles, stain, and the like.
On the other hand, since the detection of the presence or absence of the wafer at the conveying system of a device process is performed by the wafer rear surface, if the wafer rear surface treated with mirror-polishing is mirror-surface shaped, there has arisen a problem of detection difficulty, detection error, and the like.
Patent Document 1: Japanese Unexamined Patent Application Publication No. 11-233485

### Disclosure of Invention

### Problems to be Solved by the Invention

In the wafer (hereinafter referred to as PW: Polished Wafer) in which the surface of the wafer is mirror-polished as shown in the Patent Document 1, there has been a problem that it is not possible to obtain a wafer having a good flatness as desired by a device maker and being small in the rear surface roughness of the PW.

An object of the present invention is to provide a processing method of a silicon wafer, which can maintain flatness after the lapping, and at the same time, can reduce surface roughness.
Another object of the present invention is to provide a processing method of a silicon wafer, in which a good flatness is obtained and the rear surface roughness becomes small can be obtained in the wafer in which the surfaces are mirror-surface polished.

### Means for Solving the Problems

A first aspect of the invention according to claim 1 is a processing method of a silicon wafer, in which a silicon wafer having degraded superficial layers gone through a cleaning process subsequent to a lapping process is immersed into acid etching solution in which acid aqueous solution mainly composed of hydrofluoric acid and nitric acid contains phosphoric acid.
In the first aspect of the invention according to claim 1, when an etching is performed by the acid etching solution acid aqueous solution mainly composed of hydrofluoric acid and nitric acid containing phosphoric acid, the flatness after the lapping can be maintained, and at the same time, the surface roughness can be reduced.

A second aspect of the invention according to claim 2 is the first aspect of the invention according to claim 1, and is a processing method, in which, when the acid aqueous water solution mainly composed of hydrofluoric acid and nitric acid is made 100 percent by weight, the acid aqueous water solution contains phosphoric acid 30 to 40 percent by weight.

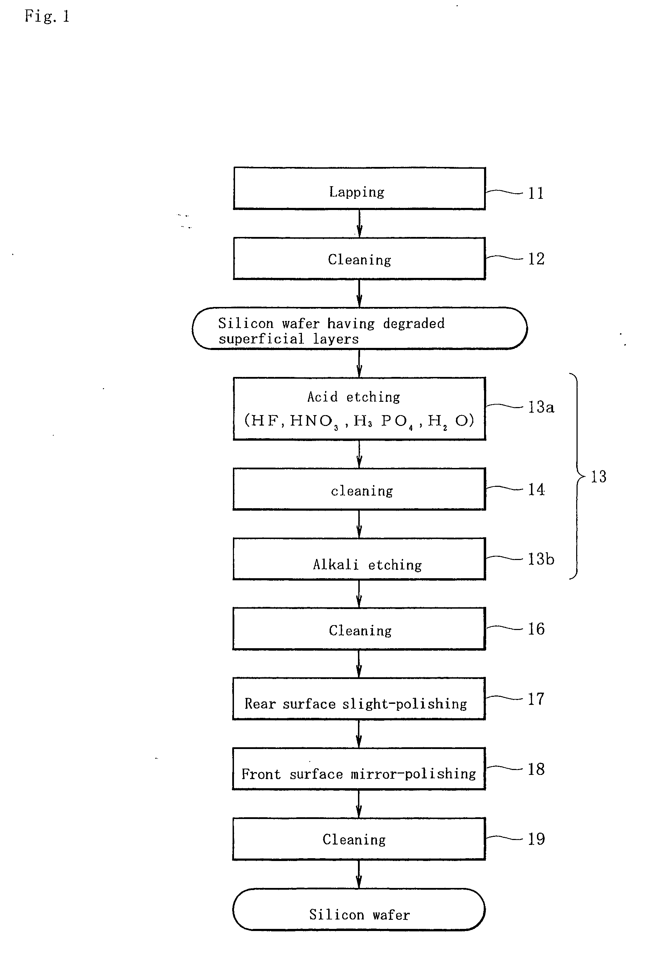

A third aspect of the invention according to claim 3, as shown in Fig. 1, is the improvement of the manufacturing method of the silicon wafer including an etching process 13 in which the acid etching solution and the alkali etching solution are stored respectively in plural etching tanks, and subsequent to a lapping process 11, the silicon wafer gone through a cleaning process 12 and having degraded superficial layers is immersed into the acid etching solution and the alkali etching solution in order, a front surface mirror-polishing process 18 to mirror-polish the one side of the etched wafer, and a cleaning process 19 to clean the front surface mirror-polished wafer, and the characteristic of this constitution lies in the fact that the etching process 13 is a process in which the alkali etching is performed after the acid etching, and the acid etching solution contains phosphoric acid equal to or more than 30 percent by weight in acid aqueous water solution 100 percent by weight which is mainly composed of hydrofluoric acid and nitric acid.
In the third aspect of the invention according to claim 3, by going through the processes 11 to 19, a silicon wafer in which a good flatness is obtained and the rear surface roughness becomes small can be obtained in the wafer in which the front surface is mirror-polished.

A fourth aspect of the invention according to claim 4 is the third aspect of the invention according to claim 3, and as shown in Fig. 1, is a processing method further including a rear surface slight-polishing process 17 to polish part of unevenness of the wafer rear surface formed by the etching process 13 between the etching process 13 and the front surface mirror-polishing 18.
In a fourth aspect of the invention according to claim 4, by performing the rear surface slight-polishing process on the wafer rear surface, the rear surface roughness is reduced.

A fifth aspect of the invention according to claim 5 is the third aspect of the invention according to claim 3, and is a processing method in which, when the acid aqueous water solution composed mainly of hydrofluoric acid and nitric acid is made 100 percent by weight, the acid aqueous water solution contains phosphoric acid 30 to 40 percent by weight.

A sixth invention according to claim 6 is the third aspect of the invention according to claim 3, and is a processing method in which the acid etching in the etching process 13 is performed by a spin-coating method in which the acid etching solution is dripped on the silicon wafer, and the wafer is spun so that the dripped acid etching solution is expanded on the whole wafer surface.

### Effects of the Invention

As described above, according to the processing method of the present invention, when the etching is performed by the acid etching solution containing phosphoric acid in the acid aqueous solution mainly composed of hydrofluoric acid and nitric acid, the flatness after the lapping can be maintained, and at the same time, the surface roughness can be reduced.
Further, the processing method of the present invention includes the etching process to immerse a silicon wafer having degraded superficial layers into the acid etching solution and the alkali etching solution in order, the front surface mirror-polishing process to mirror-polish one side of the etched wafer, and a cleaning process to clean the front surface mirror-polished wafer, and the etching process is performed by the alkali etching after the acid etching, and by performing the processing method of a silicon wafer of the present invention, in which the acid etching solution contains phosphoric acid equal to or more than 30 percent by weight in the acid aqueous water solution 100 percent by weight mainly composed of hydrofluoric acid and nitric acid, a silicon wafer in which a good flatness is obtained and the rear surface roughness becomes small can be obtained in the wafer in which the front surface is mirror-surface polished.

### Best Mode for Carrying out the Invention

Next, the best mode of carrying out the invention will be described based on the drawings.
First, a grown silicon single crystal ingot is cut at the top end and the trailing end so as to become block-shaped, and to make the diameter of the ingot uniform, the outer diameter of the ingot is grinded so as to become a block body. To show a specific crystal orientation, this block body is given an orientation flat or an orientation notch. After this process, the block body is sliced with a predetermined angle given to the axial direction of the ingot.
The sliced wafer, to protect a crack and a chip on the periphery of the wafer, is subjected to a chamfering process on the periphery of the wafer. By performing this chamfering process, a crown phenomenon can be controlled, in which an abnormal growth arises in the periphery when, for example, an epitaxial growth develops on the silicon wafer not chamfered and circularly swells. As shown in Fig. 1, the uneven layer of the wafer surface arisen by the slicing process is mechanically polished (lapped), and the flatness of the wafer surface and the parallelism of the wafer are enhanced (process 11). The wafer treated with the lapping process 11 is cleaned in the cleaning process 12, and is sent to the next process.

Subsequently, the mechanical degraded superficial layers of the wafer introduced by the chamfering process and the lapping process 11 is completely removed by etching (process 13).
In the etching process 13 of the present invention, acid etching solution and alkali acid solution are stored in plural etching tanks, respectively, and the silicon wafer is immersed into the acid etching solution and the alkali etching solution in order. Further, the etching process 13 is performed by the alkali etching 13b after the acid etching 13a. The surface of the wafer etched respectively in this order has few facet having a large size, and moreover, the generation of a deep pit can be also controlled. Further, the acid etching in the etching process 13 may be performed by a spin coat method in which the acid etching solution is dripped on the silicon wafer, and the wafer is spun so that the dripped acid etching solution is expanded on the whole wafer surface.

The acid etching solution used in the acid etching 13a contains phosphoric acid equal to or more than 30 percent by weight in the aqueous water solution 100 percent by weight mainly composed of hydrofluoric acid and nitric acid. By using the acid etching solution containing phosphoric acid 30 percent by weight, the flatness after the lapping is maintained, and at the same time, the surface roughness can be reduced. When the acid aqueous water solution mainly composed of phosphoric acid and nitric acid is made 100 percent by weight, it is preferable that the acid etching solution is prepared to contain phosphoric acid 30 to 40 percent by weight.
The alkali etching solution used in the alkali etching 13b contains sodium hydrate or potassium hydrate, and further, may contain lithium hydrate.

Further, there is a need to perform a rinse process between each etching process. For example, between the acid etching process 13a and the alkali etching process 13b, there is provided a cleaning process 14 to perform a pure water rinse. By inserting the rinse cleaning process 14 in between, acid and alkali adhered to the wafer are cleansed away, and therefore, in the process to continue subsequently, the carrying over of the detergent from the etching tank of the preceding process can be prevented, and fluctuation of the composition of the detergent can be controlled to the minimum.
The wafer having completed the etching process 13 is washed away from the detergent adhered on the surface by a cleaning process 16, and is sent to the next process.

Next, a rear surface slight-polishing process to polish a portion of the unevenness of the wafer rear surface formed by the etching process 13 is performed (process 17). By performing this rear surface slight-polishing on the wafer rear surface, the roughness of the rear surface is reduced.
In the rear surface slight-polishing process 17 and the subsequent front surface mirror-surface polishing process 18, one surface polishing method is used. For the polisher used in these processes 17 and 18, one surface polisher may be used or a double surface polisher may be used to perform one surface polishing. The wafer rear surface removal depth by the rear surface slight-polishing process 17 is made below 1 µm or preferably below 0.3 µm. If it exceeds 1 µm, glossiness does not become the value desired by the device maker, and is hard to distinguish between the front and rear surfaces. By this rear surface slight-polishing 17, the shape of the wafer rear surface is controlled in rear surface roughness to the predetermined range.

The wafer having completed the rear surface slight-polishing process 17 is subjected to the mirror-polishing combining mechanical or physical polishing of the front surface with chemical polishing, whereby the wafer is turned into a polished wafer having chemical glossiness and no work distortion (process 18).
The wafer having completed the front surface mirror-polishing is cleaned (process 19), and is sent to a device production process. By going through the processes 11 to 19 of the present invention, a silicon wafer in which a good flatness is obtained, and moreover, the rear surface roughness becomes small can be obtained in the wafer in which the front surface is mirror-polished.

### Examples

Next, examples of the present invention will be described in detail together with a comparative example.
<First Example>
First, a silicon single crystal ingot was sliced, and a silicon wafer having degraded superficial layers gone through cleaning subsequent to chamfering and lapping was prepared. Hydrofluoric acid, nitric acid, phosphoric acid, and water were mixed so that a volume ratio of (HF: HNO₃: H₃PO₄: H₂O) becomes 1:8:6:5, thereby preparing an acid etching solution. The prepared acid etching solution was stored in an etching tank, and solution temperature was maintained at 80°C. The alkali etching solution containing the potassium hydrate of 48 percent by weight was prepared, and this alkali etching solution was stored in the etching tank, and solution temperature was maintained at 80°C.
Next, the acid etching solution within the acid etching tank was stirred, while the wafer was immersed, and the alkali etching was performed so that the removal depth of the wafer becomes 20 µm in the total of the front and rear surfaces. The wafer having completed the acid etching was immersed into a ultrapure water, and was treated with rinse.
Next, the alkali etching solution within the alkali etching tank was stirred, while the wafer was immersed, and the alkali etching was performed so that the removal depth of the wafer becomes 5 µm in the total of the front and rear surfaces. The wafer having completed the alkali etching was immersed into a ultrapure water, and was treated with rinse, thereby obtaining a wafer.

### <Second Example>

The removal depth of a wafer in acid etching was made 12 µm in the total of the front and rear surfaces, and the removal depth of a wafer in alkali etching was made 11 µm in the total of the front and rear surfaces. Otherwise, the etching was performed similarly to the first example.

### <Comparative Example 1>

Hydrofluoric acid, nitric acid, acetic acid, and water were mixed so that the percent by weight of (HF: HNO₃: CH₃COOH: H₂O) becomes 1:8:6:5, thereby preparing an acid etching solution, and the removal depth of a wafer in acid etching was made 12µm in the total of the front and rear surfaces, and the removal depth of a wafer in alkali etching was made 12 µm in the total of the front and rear surfaces. Otherwise, the etching was performed similarly to the first example.

### <Comparison Test and Evaluation>

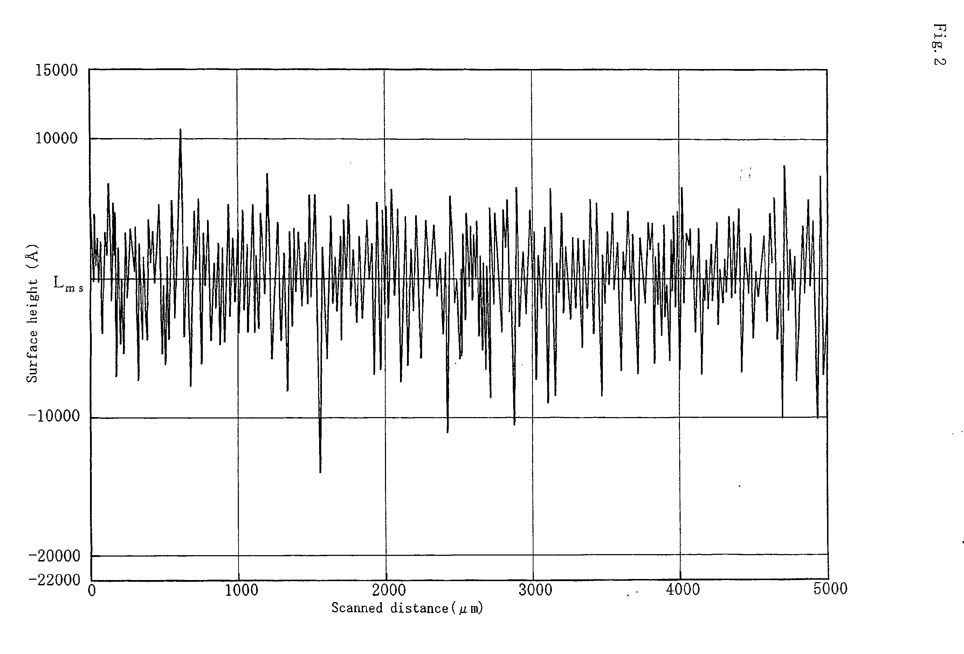

The predetermined positions of the wafer surface obtained in the first and second examples and the comparative example 1 were scanned by using a roughness measuring instrument, and the surface roughness was measured. The measurement result of the surface roughness is shown in Figs. 2 to 4, and an average roughness Ra in each surface roughness measurement result, a root-mean-square roughness Rₘₛ, and the maximum value R_{P-V} of the roughness (peak-to-valley) are shown in Table 1, respectively. Lₘₛ in Figs. 2 to 4 shows a mean surface level.

**Table 1**

| | Acid etching solution | Total removal depth of front and rear surfaces [µm] | | Average roughness Ra [A] | Root-mean-square roughness Rₘₛ[Å] | Maximum value of roughness Rₚᵥ[Å] |
|---|---|---|---|---|---|---|
| | | Acid | Alkali | | | |
| Example 1 | Hydrofluoric acid nitric acid phosphoric acid water =1 8 6 5 | 20 | 8 | 2452.80 | 3165.09 | 24870.80 |
| Example 2 | Hydrofluoric acid nitric acid phosphoric acid water =1: 8: 6: 5 | 12 | 11 | 2932.65 | 3764.69 | 31172.44 |
| Comparative example 1 | Hydrofluoric acid nitric acid acetic acid water =1: 8: 6: 6 | 12 | 12 | 4119.73 | 5223.79 | 36016.68 |

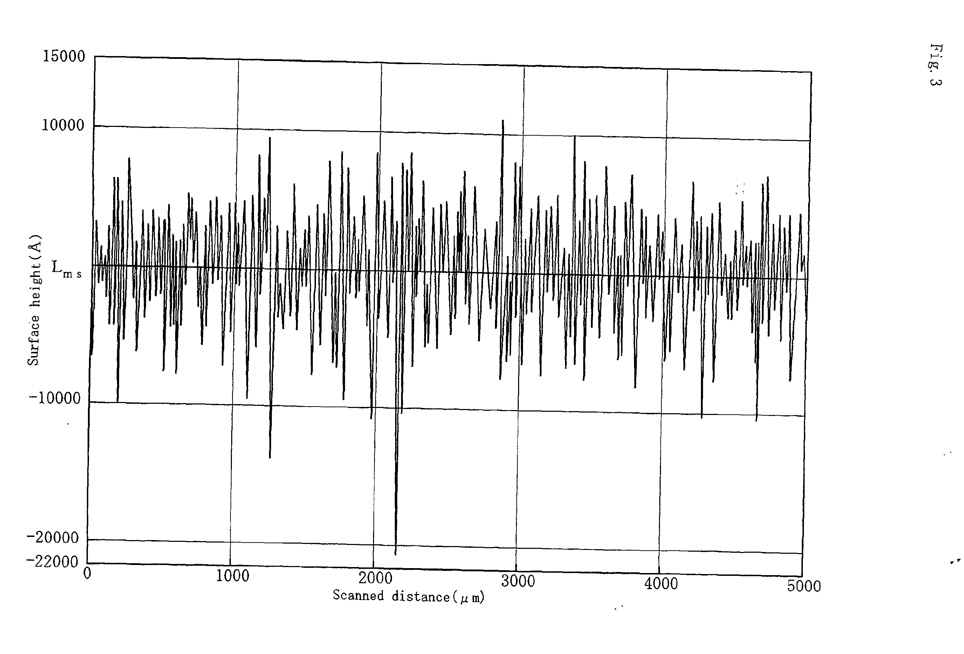

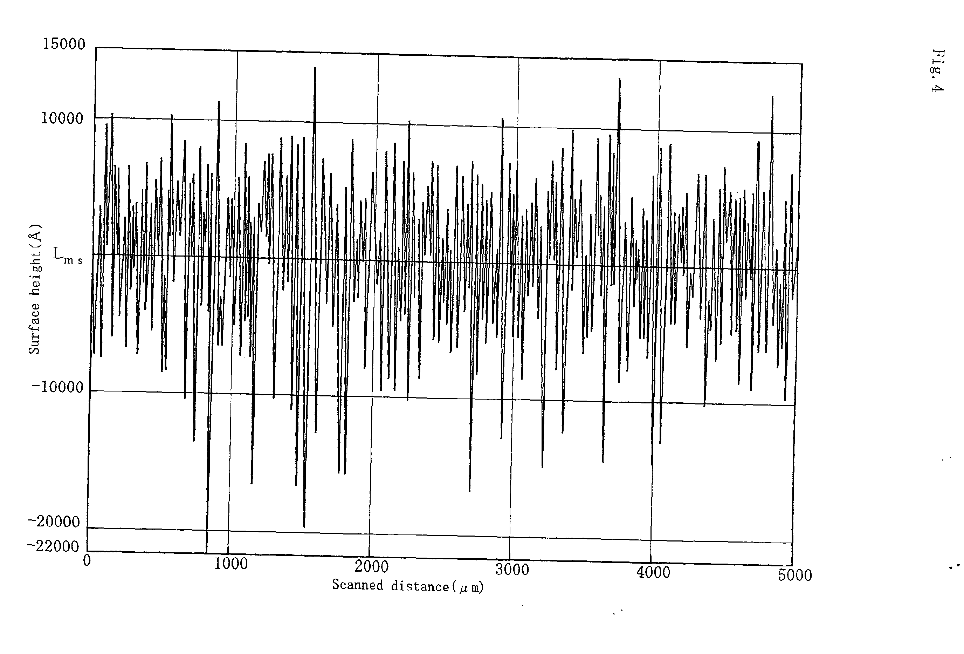

As evident from Fig. 4 and Table 1, in the comparative example 1 having performed the etching by using the acid etching solution containing acetic acid, the surface roughness is large, and R_{P-V} showing the absolute value of a surface height also represents a large numerical value. In contrast to this, as evident from Figs. 2 and 3, in the first and second examples, despite of the same manufacturing condition, it is appreciated that the surface roughness has been sharply improved. In particular, it is appreciated that the first example where a ratio of the total removal depth by the acid etching is made large can attempt at further reduction of the surface roughness.

### Industrial Applicability

The processing method of a silicon wafer of the present invention can be applied to etching-remove degraded superficial layers of the wafer surface generated in the wafer manufacturing process.

### Brief Description of the Drawings

Fig. 1 is a process drawing showing the processing method of a silicon wafer of the present invention;
Fig. 2 is a surface roughness measurement drawing of the wafer obtained in a first example;
Fig. 3 is a surface roughness measurement drawing of the wafer obtained in a second example; and
Fig. 4 is a surface roughness measurement drawing of the wafer obtained in a comparative example 1.

### Reference Numerals

- 11:: Lapping process
- 12:: Cleaning process
- 13:: Etching process
- 13a:: Acid etching
- 13b:: Alkali etching
- 17:: Rear surface slight-polishing process
- 18:: Front surface mirror-polishing process
- 19:: Cleaning process

## Claims

1. A processing method of a silicon wafer to immerse a silicon wafer having degraded superficial layers gone through a cleaning process subsequent to a lapping process into acid etching solution containing phosphoric acid in acid aqueous water solution mainly composed of hydrofluoric acid and nitric acid, thereby etching said wafer.

2. The processing method according to claim 1, wherein, when the acid aqueous water solution mainly composed of hydrofluoric acid and nitric acid is made 100 percent by weight, said acid aqueous water solution contains phosphoric acid 30 to 40 percent by weight.

3. A processing method of a silicon wafer, including :
an etching process (13) storing acid etching solution and alkali etching solution in plural etching tanks, respectively, and immersing a silicon wafer having degraded superficial layers gone through a cleaning process (12) subsequent to a lapping process (11) into the acid etching solution and the alkali etching solution in order,
a front surface mirror-polishing process (18) to mirror-polish one surface of said etched wafer, and
a cleaning process (19) to clean said front surface mirror-polished wafer,
wherein said etching process (13) is a process in which the alkali etching is performed after the acid etching, and
wherein said acid etching solution contains phosphoric acid equal to or more than 30 percent by weight in the acid aqueous water solution 100 percent by weight mainly composed of hydrofluoric acid and nitric acid.

4. The processing method according to claim 3, further including a rear surface slight-polishing process (17) to polish a portion of the unevenness of the wafer rear surface formed by said etching process (13) between the etching process (13) and the front surface mirror-polishing process (18).

5. The processing method according to claim 3, wherein, when the acid aqueous water solution mainly composed of hydrofluoric acid and nitric acid is made 100 percent by weight, said acid aqueous water solution contains phosphoric acid 30 to 40 percent by weight.

6. The processing method according to claim 3, wherein the acid etching in the etching process (13) is performed by a spin-coating method, in which the acid etching solution is dripped on the silicon wafer, and said wafer is spun so that said dripped acid etching solution is expanded on the whole wafer surface.
